# EUROPEAN PATENT SPECIFICATION

(11) **EP 4 602 650 B1**
(45) Date of publication and mention of the grant of the patent: **02.12.2026**
(21) Application number: 23785782.6
(22) Date of filing: 05.10.2023
(51) Int. Cl.: H10W 40/22, H05K 1/185, H05K 3/00, H10W 40/77, H10W 70/05, H10W 70/09, H10W 70/60, H10W 70/68, H10W 90/00

(54) **COMPONENT CARRIER WITH PROTRUDING THERMAL STRUCTURE, AND MANUFACTURE METHOD**
KOMPONENTENTRÄGER MIT VORSTEHENDER THERMISCHER STRUKTUR UND HERSTELLUNGSVERFAHREN
SUPPORT DE COMPOSANT À STRUCTURE THERMIQUE EN SAILLIE, ET PROCÉDÉ DE FABRICATION

(30) Priority: 12.10.2022 CN 202211247601
(43) Date of publication of application: 20.08.2025
(73) Proprietor: AT & S Austria Technologie & Systemtechnik Aktiengesellschaft, 8700 Leoben-Hinterberg (AT)
(72) Inventor: MOK, Jeesoo, Chongqing, Sichuan 401120 (CN)
(74) Representative: Donatello, Daniele
(86) International application number: PCT/EP2023/077638
(87) International publication number: WO 2024/078972

(56) References cited:
- US-A1- 2019 051 612
- US-A1- 2019 393 117
- US-A1- 2022 028 842

## Description

### Field of the Invention

The invention relates to a component carrier with a stack, an electronic component, and a thermal structure that comprises a plurality of protrusions. Further, the invention relates to a method of manufacturing the component carrier.

Thus, the invention may relate to the technical field of component carriers such as printed circuit boards and IC substrates, in particular in the context of heat dissipation.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically and magnetically reliable so as to be operable even under harsh conditions. One such component carrier is disclosed in US 2019/393117 A1.

In particular, dissipating heat from heat-producing electronic components (e.g. embedded chips) may be considered a challenge, especially in the field of coreless component carriers such as fan-out wafer level packages (FOWLP).

### Summary of the Invention

There may be a need to enhance the heat dissipation capacity of a component carrier.

A component carrier, and a manufacture method are provided.

According to a first aspect of the invention, a component carrier is described as claimed in claim 1.

According to a second aspect of the invention, a method for manufacturing a component carrier is described as claimed in claim 11.

Out of the scope of the present invention but useful to understand it, it is described a semi-finished product, comprising or consisting of a manufacture stack that has:
i) a high temperature resistant layer, in particular a dry film resist,
   in particular wherein the high temperature resistant layer comprises recesses filled with a plurality of protrusions; and
ii) a photo-imageable dielectric, PID, layer structure on top of the high temperature resistant layer,

in particular wherein the PID layer structure comprises a base structure cavity filled with a base structure,
more in particular wherein the thickness of the manufacture stack is 300 µm or less.

In the context of the present document, the term "thermal structure" may particularly denote any structure suitable to dissipate heat in the context of a component carrier. In a basic example, a thermal structure may be a metal plate or metal block, since metal efficiently guides heat (in comparison to insulating component carrier materials such as resins). Alternatively, a thermal structure can be a plate or block done in electrical insulating material but having a good thermal conductive properties. In a more advanced example, a thermal structure may comprise so-called fins that distribute heat away from the component carrier. This may be done especially efficient due to a large surface area of the fins/protrusions. In a preferred example, a thermal structure comprises a base (layer) structure and a protruding portion, wherein the base structure is configured to function as a support of the protruding portion.

In the context of the present document, the term "protruding portion" may particularly denote a structure mounted on or connected to a base structure that extends away from the base structure. For example, a plurality of column-shaped (e.g. rectangular or circular) structures may be connected to the base structure. According to one embodiment, said structure may comprise the above mentioned fins.

In a further embodiment, the protruding portions can (at least partly) have a pattern distribution or different distributions, such as a peripheral distribution (with respect to the thermal structure and/or the component carrier), a random distribution, etc.

In an example, the base structure may be mounted on a component carrier main surface (in particular partially embedded in the component carrier), while the protruding portions extend away from the component carrier, thereby dissipating heat beyond the main surface.

In the context of the present document, the term "electronic component" may in particular refer to any component that may be embedded in a component carrier and is electrically connected/connectable to an electrically conductive layer structure of the component carrier. The electronic component may hence be an active component (e.g. an IC) or a passive component (e.g. a capacitor).

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In an embodiment, the component carrier comprises a (layer) stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

According to an exemplary embodiment, the invention may be based on the idea that the heat dissipation capacity of a component carrier can be enhanced, when a thermal structure is applied at a main surface of the component carrier and above a heat producing component, wherein the thermal structure comprises a plurality of protruding portions that transport the heat from the component beyond the main surface of the component carrier.

Conventionally, heat dissipation structures guide the heat, produced by an electronic component, along the component carrier layer stack in a horizontal direction (e.g. by a heat pipe). Alternatively, metal vias or metal blocks may dissipate heat in the vertical direction through the stack. Since the heat passes through a large part of the component carrier, the conventional heat paths may not be very efficient.

However, according to the invention, the heat may be directly transferred from the heat producing component through the base structure (on top of the component), and the plurality of protrusions, away from the component carrier main surface. Such a heat path may be especially efficient, especially in case of coreless applications. Regarding the manufacture, the thermal structure may serve as a surprisingly efficient and robust basis for further layer build-up and may thus be used as the supporting substrate during component carrier manufacturing.

### Exemplary Embodiments

According to an embodiment, the component carrier further comprises a redistribution layer structure, at least partially embedded in the stack and configured to electrically connect the embedded electronic component to a further main surface of the stack. This may provide the advantage that small electric component pads may be securely connected to larger pads at the further main surface. Accordingly, robust and reliable electric connection of the component may be enabled. The component carrier may hereby serve as an interposer.

According to a further embodiment, the further main surface is opposed to the main surface. This may provide the direction of the exchanged heat path away from the redistribution structure, the latter being preferably connected to additional component and/or an additional component carrier (i.e. a PCB) the functionality of that can be affected by the exchanged heat.

According to a further embodiment, the component carrier is configured as a coreless component carrier. In general, a component carrier comprises a (central) core layer structure that provides stability and robustness. Often, the core is formed by a fully cured insulating material such as FR4, i.e. no prepreg (not fully cured). A coreless component carrier may provide the advantage that it is thinner and can be applied in a more flexible manner.

According to a further embodiment, the component carrier is configured as a fan-out wafer-level-package or a fan-out panel-level-package.

According to a further embodiment, the component carrier is configured as a high density package for (moderate) heat production.

According to a further embodiment, the thermal structure is configured as an integral part of the stack. This may provide the advantage that stack and thermal structure are connected in a robust and stable manner. For example, the base structure may be part of one or more layer structures of the stack. In a specific example, the base structure is surrounded by a solder mask layer structure. In another example, the base structure may be surrounded by one or more other layer structures of the stack. In an example, only the base structure and not the protrusion portion is integrated with the stack.

The base structure is the outermost layer of the stack/component carrier. This may provide the advantage that the heat produced by the electronic component may be directly guided away from the main surface (minimal distance) instead of being transported through the stack.

According to a further embodiment, the thermal structure further comprises a coating layer, in particular a surface finish, that covers the plurality of protrusions. This may provide the advantage that the protrusions are efficiently protected against oxidation without hindering the dissipation of heat. In particular, the coating layer may comprise a material that efficiently dissipates heat, comparable to the protrusion material. Examples of suitable surface finish materials are provided further below.

According to a further embodiment, the plurality of protrusions comprises a height in the range 100 µm to 200 µm. This range may be an optimal compromise between a low height of the component carrier and an efficient heat dissipation.

According to a further embodiment, the plurality of protrusions comprises essentially vertical sidewalls, in particular thereby reflecting a manufacture step of photolithography. As will be described below, the photolithography methodology may be applied when manufacturing the protrusions. It may be inherent to photolithographic methods to form vertically (essentially) straight sidewalls in comparison to etching or laser-drilling. Hence, the essentially vertical sidewalls may be a structural feature that directly reflects the manufacture process.

According to a further embodiment, the protrusions of the plurality of protrusions comprise the same shapes or different shapes. Depending on the desired application, similar or different shapes may be preferred.

According to a further embodiment, the base structure comprises a larger width than the electronic component. Thereby, an especially efficient heat dissipation may be enabled.

According to a further embodiment, the electronic component is embedded in a cavity, in particular encapsulated in the cavity, and wherein the base structure comprises a larger width than the cavity. This design may also allow for an especially efficient heat dissipation (thermal path). Further, the thermal structure may be applied as a support structure to build-up the layer stack. In this embodiment, a base structure with a larger width (than the component/cavity) may be a robust support for embedding (and encapsulating) the electronic component in the cavity.

According to a further embodiment, a thermal path (T) is established directly from the electronic component to the thermal structure without an electrically insulating material in between or the thermal path (T) is established from the electronic component to the thermal structure with at least one layer structure in between, in particular an adhesive layer.

A direct connection may enable and especially reliable heat flow without any interruption. The adhesive layer in turn may be advantageous, when placing the component in the cavity. Hereby, the adhesive layer may be very thin, so that it may have only a negligible effect on the heat dissipation.

The component carrier further comprises a vertical electric connection embedded in the stack, in particular wherein the vertical electric connection extends through the stack, wherein an upper part of the vertical electric connection is electrically connectable at the main surface of the stack. Such a through connection may enable a variety of approaches, depending on the indented functionality. The vertical electric connection may comprise a plurality of electrically conductive layer structures (traces) and electrically conductive vias (e.g. filled with copper).

The component carrier further comprises:
a metal structure arranged besides the thermal structure, wherein the metal structure extends at least partially beyond the main surface, in particular wherein the metal structure forms the outermost portion of the vertical electric connection. This structural feature may directly reflect a manufacture step of forming the metal structure (and the outermost portion of the vertical electric connection) together with the thermal structure, e.g. by a photolithographic process.

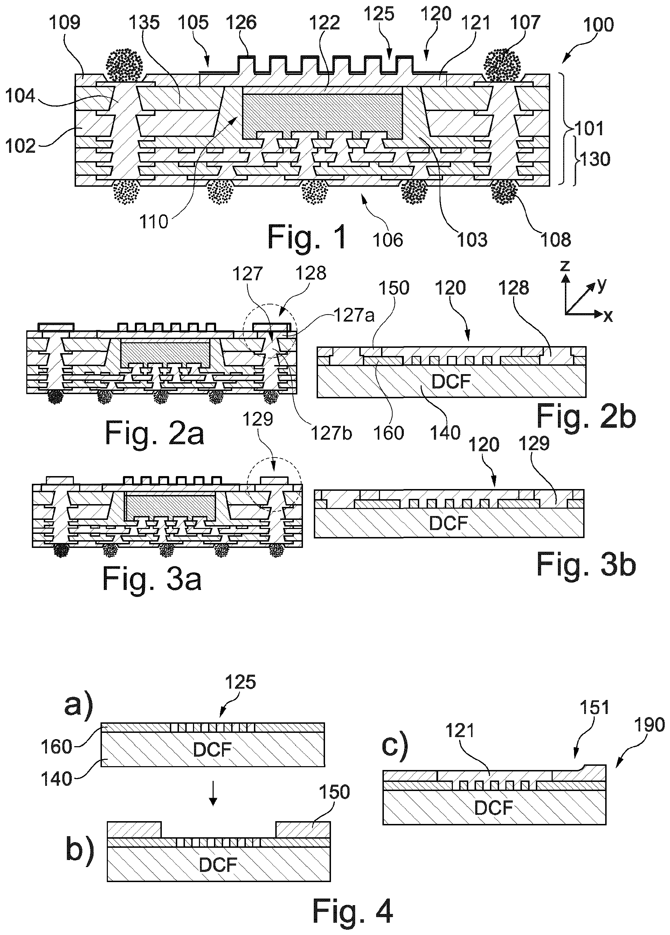

According to a further embodiment, the metal structure comprises a larger width or a smaller width than the upper part (outermost part) of the vertical electric connection (see Figures 2 and 3 below). Depending on the desired application, either a robust support or a more reliable electric connection may be preferred.

The metal structure comprises the same height as the plurality of protrusions.

According to a further embodiment, the upper part of the vertical electric connection is arranged at the same vertical height (z) as the base structure. These structural features may directly reflect a manufacture step, in which the metal structure and the thermal structure are manufactured together, since both were formed in one and the same layer.

According to a further embodiment, the component carrier further comprises an adhesive layer, embedded in the stack and arranged (at least partially) below the thermal structure. Said adhesive layer may be arranged between the thermal structure and an electrically insulating layer structure of the stack. In a specific example, the adhesive layer comprises a DAF (die attaching film).

According to a further embodiment, the component carrier further comprises a protection layer embedded in the stack. The electronic component (and the encapsulation material) may be surrounded by the protection layer.

According to a further embodiment, the method further comprises: forming the thermal structure on a temporary carrier, in particular a fabric-based (e.g. a non-woven and/or composite) temporary carrier, more in particular a Dyneema composite fabric (DCF) temporary carrier. DCF is a composite fabric with a non-woven, laminate material. DCF may be especially efficient for high strength and low weight applications. Accordingly, a DCF carrier may be advantageously applied for the manufacture method.

According to a further embodiment, the method further comprising:
i) providing a high temperature resistant dielectric layer, in particular a dry film resist/photoresist;
ii) patterning the high temperature resistant dielectric layer to obtain a structured layer; and
iii) forming the plurality of protrusions in recesses of the structured layer, in particular by plating.

In an example, the plurality of protrusion are formed on a temporary carrier (in particular the DCF carrier) in recesses of the high temperature resistant dielectric layer (preferably dry film). Hereby, even small structures (microstructures) with vertically straight sidewalls may be obtained. Patterning of the high temperature resistant dielectric layer may be done by photolithography, in particular when the high temperature resistant dielectric layer is a photoresist (polymer dry film).

A photoresist may in general protect metal paths which shall not be etched away, while metal areas which shall be etched away are not covered with the photoresist. At first, for this purpose, an entire layer is coated with the photoresist. Then, through a mask, the photoresist is developed by UV-light. The mask passes UV-light only at positions, where the photoresist shall remain (i.e. where the desired conductor traces shall be provided). During developing, the resist (and the polymer, respectively) is cross-linking at the positions which have been exposed to UV-light. After developing, the photoresist which was not exposed (and not developed, respectively) can be easily washed away. In the present case, a photoresist may not be applied to protect metal paths, but to form cavities in which the protrusion may be formed (e.g. plated).

According to a further embodiment, the method further comprising:
i) forming a photo-imageable dielectric, PID, layer structure on the high temperature resistant layer, in particular on the structured layer with the plurality of protrusions;
ii) removing a part of the PID structure, thereby forming a base structure cavity; and
iii) forming the base structure in the base structure cavity.

In the context of the present document, the term "photo-imageable dielectric layer structure" may refer to any dielectric (layer) structure that is configured to be treated (shows an effect) using photo-imaging. In particular, the term refers to a PID dielectric layer structure into which a cavity can be formed using (only) photo-imaging techniques. Preferably, a PID layer structure comprises a non-fiber enforced resin, e.g. polyimide. A base material for a PID application may include: i) thermosetting material, e.g. epoxy, BCB, phenol, ii) thermoplastic material: PI, PBO. The PID material may further comprise a photo initiator (photo sensitive agent) that may be cured by electromagnetic waves e.g. visible light and/or UV light. The PID material may be laminated on a substrate (e.g. the stack) and may then be exposed to a lithographic source via a pattern mask, wherein the pattern mask defines the to be manufactured cavities. Additionally and/or alternatively, the PID material may be applied by other techniques e.g. spraying, spin coating and/or slit coating. A portion of the PID material may be developed (exposed to electromagnetic waves) and one of an exposed portion and an unexposed portion (positive or negative photolithography may be used) may be removed to obtain a plurality of cavities. Examples of photolithography processes may include X-ray lithography, UV lithography, stereo lithography, e-beam lithography and laser lithography.

According to a further embodiment, the photo-imageable material comprises advanced adhesion properties (said adhesion properties may be created be the PID material and/or by adhesion promoting additives). This may provide the advantage that the layer structure may stick to the porous layer structures in an efficient and stable manner. Further, the metal layer structure may be reliably attached to such an adhesive layer structure. This may provide a particular advantage, because copper/resin interfaces tend to be unstable regarding adhesion, in particular if no additional surface roughing is provided. Further, the adhesion may promote a stable connection with component carrier material.

According to a further embodiment, the photo-imageable material comprises or consists of a polymer, in particular a mixture of polymers. This may provide the advantage that adhesion properties may be enhanced, particularly by hydrophobic interaction of polymer(s).

According to a further embodiment, the photo-imageable material comprises or consists of photo-imageable dielectric, PID, material the photo-imageable material comprises additives, in particular conjugated pi systems.

The term "conjugated pi system" may refer to a system of connected p-orbitals with delocalized electrons in a molecule, which in general lowers the overall energy of the molecule and increases stability. Examples of such systems may include aromatic (in particular heterocycles), non-aromatic, and anti-aromatic compounds. Specific examples may include nitrogen-compounds (in particular imidazole), phosphorus-compounds, oxygen compounds, or sulfur-compounds.

According to a further embodiment, the method further comprising: forming the base structure subsequently to forming the plurality of protrusions on top of the plurality of protrusions, in particular by plating. Plating may be done directly on top of the plurality of protrusions. In this manner, the base structure and the protrusions may be connected.

The semi-finished product (the high temperature resistant dielectric layer and the PID layer structure) comprises a height of 300 µm or less, in particular 250 µm or less.

In an embodiment, the stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

### Brief Description of the Drawings

The aspects defined above and further aspects of the invention are apparent from the examples of embodiment to be described hereinafter and are explained with reference to these examples of embodiment.
Figure 1 illustrates a component carrier useful to understand but out of the scope of of the invention.
Figures 2a, 2b, 3a, and 3b illustrate further component carriers according to exemplary embodiments of the invention.
Figures 4a to 4c illustrate a method of manufacturing a component carrier according to an exemplary embodiment of the invention.
Figures 5a to 5f illustrate a method of manufacturing a component carrier useful to understand but out of the scope of the invention.
Figure 6 illustrates heat dissipation of the component carrier useful to understand but out of the scope of the invention.
Figures 7 and 8 illustrate the component carrier with additionally mounted components useful to understand but out of the scope of the invention.

### Detailed Description of the Drawings

The illustrations in the drawings are schematic. In different drawings, similar or identical elements are provided with the same reference signs.

**Figure 1** illustrates a component carrier 100 useful to understand but out of the scope of the invention. The component carrier 100 can be a coreless component carrier 100 and comprises a multilayer stack 101 with a plurality of electrically conductive layer structures (copper traces, vias) and electrically insulating layer structures 102 (in particular resin). An electronic component (active or passive) 110 is embedded in the stack 101. The electronic component 110 can be encapsulated by a specific encapsulation material 103 at the sidewalls and at the bottom.

On top of the electronic component 100, there is mounted a thermal structure 120, configured to dissipate thermal energy (heat) produced by the electronic component 110 towards and beyond a main surface 105 of the stack 101. In the present example, said main surface 105 is the upper main surface that is parallel to the directions of main extension (along the x- and y-axes) of the component carrier 100.

The thermal structure 120 comprises a base structure 121 that is mounted on the stack 101 (in particular on the electronic component 110), and is preferably additionally embedded in a solder resist layer structure 109 of the component carrier 100, so that the base structure 121 is flush with the solder resist layer structure 109. Thus, the base structure 121 can be the outermost layer (together with said solder resist layer structure 109) of the stack 101. It can be seen that the base structure 121 preferably comprises a larger width than the electronic component 110 and the cavity in which the component 110 is encapsulated 103.

Further, the thermal structure 120 comprises a plurality of protrusions 125, protruding from the base structure 121, and extending beyond the main surface 105 of the stack 101. The plurality of protrusions 125 is connected (for example monolithically connected, formed in one piece) to the base structure 121. A coating layer 126 preferably being a surface finish covers the plurality of protrusions 125.

In this example, the plurality of protrusions 125 are of the same shape, comprise a height in the range 100 µm to 200 µm, and comprise vertical sidewalls (reflecting a manufacture step of photolithography). Alternatively (at least some of) the plurality of protrusions 125 can have a different shape.

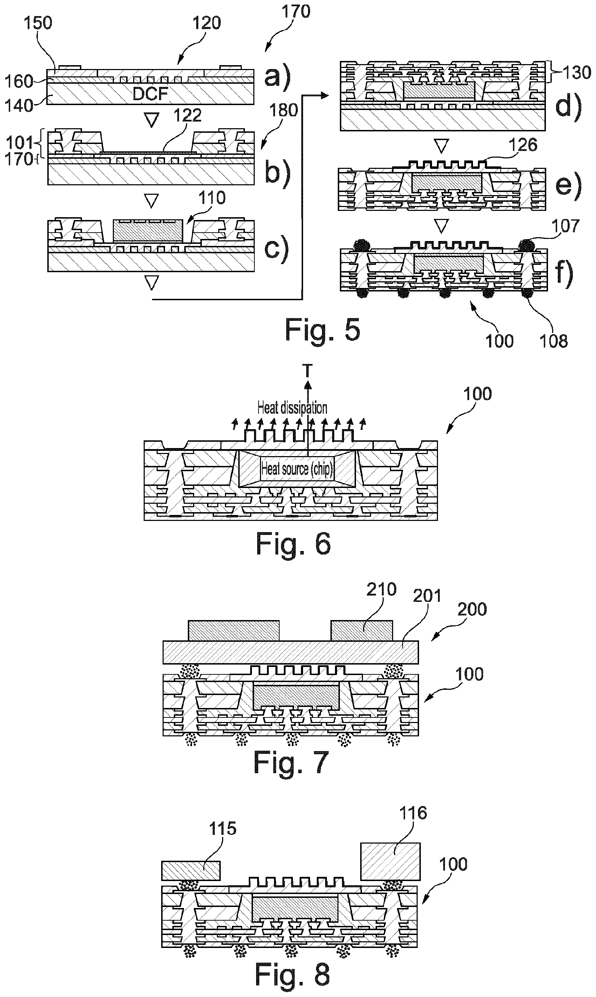

A thermal path T (see Figure 6) is preferably established directly from the electronic component 110 to the thermal structure 120) without an electrically insulating layer structure 102 in between. The preferred adhesion layer 122 shown in the Figure is not considered as an electrically insulating layer structure 102 of the stack 101.

The component carrier 100 preferably comprises a redistribution layer structure 130, comprising a plurality of metal traces and vias, that is embedded in the stack 101 and arranged below the embedded electronic component 110. Small pads at the lower main surface of the electronic component 110 are electrically connected to the redistribution layer structure 130, whereby the redistribution layer structure 130 translates the small pad electric connections to large (lower) electric connections (in this example solder balls 108) at a further main surface 106 of the stack 101, which further main surface 106 is opposite to the main surface 105.

A vertical electric connection 127 (through via) is preferably embedded in the stack 101 and extends through the stack 101. An upper part of the vertical electric connection 127a is electrically connectable at the main surface 105 of the stack 101, in this example via a solder ball 107 (upper electric connection). Finally, a protection layer 135 can be embedded in the stack 101 and is arranged directly below the thermal structure 120, yet interrupted by the electric component 110 (the protection layer 135 is arranged around the electric component 110).

**Figures 2a and 2b** illustrate a further component carrier 100 according to an exemplary embodiment of the invention.

Figure 2a: the component carrier 100 is very similar to the one described for Figure 1 but comprises instead of the upper electric connection 107 a first metal structure 128 arranged besides the thermal structure 120 (here besides the plurality of protrusions 125). The metal structure 128 extends beyond the main surface 105, and forms the outermost portion of the vertical electric connection 127, being arranged on top of the upper part of the vertical electric connection 127a. In this example, the metal structure 128 comprises a larger width than said upper part of the vertical electric connection 127a.

Figure 2b: here, the component carrier 100 of Figure 2b is shown as a semi-finished product during manufacturing. On a DCF substrate 140, there is formed the thermal structure 120 that will be later-on joined with the stack 101. A dry film resist 160 is applied between the plurality of protrusions 125, while the base structure 121 is embedded in a photo-imaginable dielectric 150. Together with the thermal structure 120, there are formed the metal structures 128 on both sides of the thermal structure 120. These will be transferred later-on together with the thermal structure 120 to the rest of the stack 101 and joined with the vertical electric connection 127. On the same level as the base structure 121, there is formed the upper part of the vertical electric connection 127a, while on the same level as the protrusions 125, there is formed the metal structure 128. As in Figure 2a, the metal structure 128 comprises a larger width than said upper part of the vertical electric connection 127a.

**Figures 3a and 3b** illustrate a further component carrier 100 according to an exemplary embodiment of the invention. The component carrier 100 of Figure 3a and the semi-finished product of Figure 3b are very similar to those described for Figures 2a and 2b above. The difference being, that in Figures 3a and 3b, the second metal structure 129 comprises a smaller width than said upper part of the vertical electric connection 127a.

**Figures 4a to 4c** illustrate a method of manufacturing a component carrier 100 according to an exemplary embodiment of the invention. A part of this method has already been described for Figures 2b and 3b above.

Figure 4a: a high temperature resistant layer 160 such as a dry film (resist) is provided on a DCF substrate 140 as a temporary carrier. The high temperature resistant layer 160 is patterned (e.g. by a photolithographic method) to obtain recesses. The recesses are filled with metal to produce a preform of the plurality of protrusions 125.

Figure 4b: a photo-imageable dielectric, PID, layer structure 150 is arranged on top of the high temperature resistant layer 160 and the protrusion 125 preforms. An opening (base structure cavity) is formed in the PID layer 150 above the protrusion 125 preforms.

Figure 4c shows a semi-finished product 190 wherein the opening in the PID layer 150 has been filled with metal (copper) to thereby form the base structure 121 directly on top of the plurality of protrusions 125. A grinding step 151 is preferably performed, so that the PID layer 150 and the base structure 121 are made flush.

**Figures 5a to 5f** illustrate a method of manufacturing a component carrier 100 useful to understand but out of the scope of the invention.

Figure 5a: the semi-finished product of Figure 4c is provided and metal traces are formed on the PID layer 150.

Figure 5b: the base structure 121 is covered by an adhesion layer 122 and build-up of the stack 101 is performed. In the first place, the protection layer 135 is formed and on top an electrically insulating layer structure 102. Through said layers, the vertical electric connection 127 is formed and electrically connected to the metal traces formed in Figure 5a. Then, a cavity is formed in the stack 101 for embedded the electronic component 110.

Figure 5c: the electronic component 110, with electric connection pads on top, is placed in the cavity and on the adhesion layer 122.

Figure 5d: a further layer build-up is performed, whereby the redistribution structure 130 is obtained.

Figure 5e: the component carrier under production is flipped and the DCF substrate 140 is removed. The dry film resist 160 is removed as well, so that the plurality of protrusions 125 is now exposed and protrudes from the component carrier main surface 105. A coating 126 (surface finish) is preferably provided to the protrusions 125. The PID layer 150 is not removed and forms in this example the solder resist layer structure 109 that surrounds the base structure 121. Thus, base structure 121 and PID layer 150/solder resist layer structure 109 are flush (have the same height).

Figure 5f: upper and lower electric connections 107, 108 in form of solder balls are provided.

**Figure 6** illustrates heat dissipation of the component carrier 100 useful to understand but out of the scope of the invention. The component carrier 100 is essentially the same as described for Figure 1. The electronic component 110 is an integrated circuit (chip) that produces a high amount of heat. Said heat is directly guided through the base structure 121 and the plurality of protrusions 125 beyond the main surface 105 of the component carrier 100. This heat dissipation path can be termed thermal path T.

**Figures 7 and 8** illustrate the component carrier 100 of Figure 1 with additionally mounted components useful to understand but out of the scope of the invention.

Figure 7: a component carrier arrangement 200 is formed by stacking a further component carrier 201 on the main surface 105 of the component carrier 100. The further component carrier 201 comprises two surface-mounted further electronic components 210 that face away from the thermal structure 120. The further component carrier 201 does not directly contact the component carrier 100, because there is a spacer structure in between, in this example the solder balls 107 are applied for this purpose. In this manner, the thermal structure 120 is not hindered in dissipating heat beyond the component carrier main surface 105.

Figure 8: a further electronic component 115 and another electronic component 116 are arranged on top of the component carrier 100. In this example, a direct electric connection is established via upper electric connections 107 of the main surface 105.

### Reference signs

- 100: Component carrier
- 101: Stack
- 102: Electrically insulating layer structure
- 103: Encapsulation material
- 104: Electrically conductive layer structure
- 105: Main surface
- 106: Further main surface
- 107: Upper electric connection
- 108: Lower electric connection
- 109: Surface finish
- 110: Electronic component
- 115: Further electronic component
- 116: Other electronic component
- 120: Thermal structure
- 121: Base structure
- 122: Adhesive layer
- 125: Protrusion
- 126: Thermal structure surface finish
- 127: Vertical electric connection, through via
- 127a: Upper part of via
- 127b: Lower part of via
- 128: First metal structure
- 129: Second metal structure
- 130: Redistribution layer structure
- 135: Protection layer
- 140: Temporary carrier
- 150: PID layer structure
- 151: Grinding
- 160: High temperature material, dry film resist
- 170: Semi-finished thermal structure
- 180: Semi-finished stack
- 190: Semi-finished product
- 200: Arrangement
- 201: Further component carrier
- 210: Further component
- T: Thermal path

## Claims

1. A component carrier (100), wherein the component carrier (100) comprises:
a stack (101) comprising at least one electrically conductive layer structure (104) and/or at least one electrically insulating layer structure (102),
an electronic component (110) embedded in the stack (101); and
a thermal structure (120), configured to dissipate thermal energy produced by the electronic component (110) towards and beyond a main surface (105) of the stack (101);
a vertical electric connection (127) embedded in the stack (101);
a metal structure (128, 129) arranged besides the thermal structure (120), wherein the metal structure (128, 129) extends at least partially beyond the main surface (105);
wherein the thermal structure (120) comprises:
a base structure (121) at least partially embedded in the stack (101), said base structure (121) being the outermost layer of the stack (101), in particular flush with one of the layer structures (102, 104) of the stack (101), and
a plurality of protrusions (125), protruding from the base structure (121), and extending beyond the main surface (105) of the stack (101); and wherein the metal structure (128, 129) comprises the same height as the plurality of protrusions (125).

2. The component carrier (100) according to claim 1, further comprising:
a redistribution layer structure (130), at least partially embedded in the stack (101) and configured to electrically connect the embedded electronic component (110) to a further main surface (106) of the stack (101),
in particular wherein the further main surface (106) is opposed to the main surface (105).

3. The component carrier (100) according to claim 1 or 2,
wherein the component carrier (100) is configured as a coreless component carrier; or
wherein the component carrier (100) is configured as a fan-out wafer-level-package or a fan-out panel level package; or
wherein the component carrier (100) is configured as a high density package for heat production; or
wherein the thermal structure (120) is configured as an integral part of the stack (101).

4. The component carrier (100) according to any one of the preceding claims, wherein the thermal structure (120) further comprises:
a coating layer (126), in particular a surface finish, that covers the plurality of protrusions (125).

5. The component carrier (100) according to any one of the preceding claims,
wherein the plurality of protrusions (125) comprise a height in the range 100 µm to 200 µm; or
wherein the plurality of protrusions (125) comprise essentially vertical sidewalls, in particular thereby reflecting a manufacture step of photolithography; or
wherein the protrusions of the plurality of protrusions (125) comprise the same shape; or
wherein the base structure (121) comprises a larger width than the electronic component (110); or
wherein the electronic component (110) is embedded in a cavity, in particular encapsulated (103) in the cavity, and wherein the base structure (121) comprises a larger width than the cavity; or
wherein a thermal path (T) is established directly from the electronic component (110) to the thermal structure (120) without an electrically insulating material in between.

6. The component carrier (100) according to any one of the preceding claims, wherein the vertical electric connection (127) extends through the stack (101), wherein an upper part of the vertical electric connection (127a) is electrically connectable at the main surface (105) of the stack (101).

7. The component carrier (100) according to any one of the preceding claims, wherein the metal structure (128, 129) forms the outermost portion of the vertical electric connection (127),
in particular wherein the metal structure (128, 129) comprises a larger width than the upper part of the vertical electric connection (127a).

8. The component carrier (100) according to claim 7,
wherein the upper part of the vertical electric connection (127a) is arranged at the same vertical height (z) as the base structure (121).

9. The component carrier (100) according to any one of the preceding claims, further comprising: an adhesive layer (122), embedded in the stack (101) and arranged below the thermal structure (120).

10. An arrangement (200), in particular a system-in-package, comprising:
a component carrier (100) according to any one of the preceding claims; and
a further component carrier (201), stacked on the main surface (105) of the component carrier (100),
in particular wherein the further component carrier (201) comprises at least one further electronic component (210).

11. A method for manufacturing a component carrier (100), the method comprising:
forming a stack (101) comprising at least one electrically conductive layer structure (104) and/or at least one electrically insulating layer structure (102);
embedding an electronic component (110) in the stack (101); and
forming a thermal structure (120), so that the thermal structure (120) dissipates thermal energy produced by the electronic component (110) towards a main surface (105) of the stack (101);
forming a vertical electric connection (127) embedded in the stack (101);
forming a metal structure (128, 129) arranged besides the thermal structure (120), wherein the metal structure (128, 129) extends at least partially beyond the main surface (105);
wherein the thermal structure (120) comprises a base structure (121) at least partially embedded in the stack (101), said base structure (121) being the outermost layer of the stack (101), in particular flush with one of the layer structures (102, 104) of the stack (101), and a plurality of protrusions (125), protruding from the base structure (121), and extending beyond the main surface (105) of the stack (101) ; and
wherein the metal structure (128, 129) comprises the same height as the plurality of protrusions (125).

12. The method according to claim 11, further comprising:
forming the thermal structure (120) on a temporary carrier (140), in particular a fabric-based temporary carrier (140), more in particular a DCF temporary carrier (140).

13. The method according to claim 11 or 12, further comprising:
providing a high temperature resistant dielectric layer (160), in particular a photoresist, more in particular a dry film resist;
patterning the high temperature resistant layer (160) to obtain a structured layer with recesses; and
forming the plurality of protrusions (125) in the recesses of the structured layer, in particular by plating.

14. The method according to claim 13, further comprising:
forming a photo-imageable dielectric, PID, layer structure (150) on the high temperature resistant layer (160), in particular on the structured layer with the plurality of protrusions (125);
removing a part of the PID structure (150), thereby forming a base structure cavity; and
forming the base structure (121) in the base structure cavity, in particular by plating.

15. The method according to any one of claims 11 to 14, further comprising:
forming the base structure (121) subsequently to forming the plurality of protrusions (125) on top of the plurality of protrusions (125), in particular by plating.

## Patentansprüche

1. Bauteilträger (100), wobei der Bauteilträger (100) Folgendes umfasst:
einen Stapel (101), der mindestens eine elektrisch leitfähige Schichtstruktur (104) und/oder mindestens eine elektrisch isolierende Schichtstruktur (102), ein in den Stapel (101) eingebettetes elektronisches Bauteil (110) und eine thermische Struktur (120) umfasst, die so ausgestaltet ist, dass sie von dem elektronischen Bauteil (110) erzeugte thermische Energie zu einer Hauptfläche (105) des Stapels (101) hin und über diese hinaus abführt;
eine vertikale elektrische Verbindung (127), die in den Stapel (101) eingebettet ist;
eine Metallstruktur (128, 129), die neben der thermischen Struktur (120) angeordnet ist, wobei sich die Metallstruktur (128, 129) zumindest teilweise über die Hauptfläche (105) hinaus erstreckt;
wobei die thermische Struktur (120) Folgendes umfasst:
eine Basisstruktur (121), die zumindest teilweise in den Stapel (101) eingebettet ist, wobei die Basisstruktur (121) die äußerste Schicht des Stapels (101) ist, insbesondere bündig mit einer der Schichtstrukturen (102, 104) des Stapels (101), und
eine Vielzahl von Vorsprüngen (125), die von der Basisstruktur (121) vorstehen und sich über die Hauptfläche (105) des Stapels (101) hinaus erstrecken; und wobei die Metallstruktur (128, 129) die gleiche Höhe wie die Vielzahl von Vorsprüngen (125) aufweist.

2. Bauteilträger (100) nach Anspruch 1, ferner umfassend:
eine Umverteilungsschichtstruktur (130), die zumindest teilweise in den Stapel (101) eingebettet und so ausgestaltet ist, dass sie das eingebettete elektronische Bauteil (110) mit einer weiteren Hauptfläche (106) des Stapels (101) elektrisch verbindet, insbesondere wobei die weitere Hauptfläche (106) der Hauptfläche (105) gegenüberliegt.

3. Bauteilträger (100) nach Anspruch 1 oder 2,
wobei der Bauteilträger (100) als ein kernloser Bauteilträger ausgestaltet ist; oder
wobei der Bauteilträger (100) als ein Fan-out-Wafer-Level-Package oder ein Fan-out-Panel-Level-Package ausgestaltet ist; oder
wobei der Bauteilträger (100) als eine High-Density-Package für die Wärmeerzeugung ausgestaltet ist; oder
wobei die thermische Struktur (120)
als integraler Bestandteil des Stapels (101) ausgestaltet ist.

4. Bauteilträger (100) nach einem der vorhergehenden Ansprüche, wobei die thermische Struktur (120) ferner Folgendes umfasst:
eine Beschichtungsschicht (126), insbesondere eine Oberflächenbehandlung, die die Vielzahl von Vorsprüngen (125) bedeckt.

5. Bauteilträger (100) nach einem der vorhergehenden Ansprüche, wobei die Vielzahl von Vorsprüngen (125) eine Höhe im Bereich von 100 µm bis 200 µm aufweist; oder
wobei die Vielzahl von Vorsprüngen (125) im Wesentlichen vertikale Seitenwände umfassen, insbesondere dadurch einen Herstellungsschritt der Photolithographie widerspiegeln; oder
wobei die Vorsprünge der Vielzahl von Vorsprüngen (125) die gleiche Form umfassen; oder
wobei die Basisstruktur (121) eine größere Breite als das elektronische Bauteil (110) umfasst; oder
wobei das elektronische Bauteil (110) in einen Hohlraum eingebettet ist, insbesondere in den Hohlraum eingekapselt (103), und wobei die Basisstruktur (121) eine größere Breite als der Hohlraum umfasst; oder
wobei ein thermischer Pfad (T) direkt von dem elektronischen Bauteil (110) zu der thermischen Struktur (120) ohne ein elektrisch isolierendes Material dazwischen hergestellt wird.

6. Bauteilträger (100) nach einem der vorhergehenden Ansprüche, wobei sich die vertikale elektrische Verbindung (127) durch den Stapel (101) erstreckt, wobei ein oberer Teil der vertikalen elektrischen Verbindung (127a) an der Hauptfläche (105) des Stapels (101) elektrisch verbindbar ist.

7. Bauteilträger (100) nach einem der vorhergehenden Ansprüche, wobei die Metallstruktur (128, 129) den äußersten Abschnitt der vertikalen elektrischen Verbindung (127) bildet, insbesondere wobei die Metallstruktur (128, 129) eine größere Breite als der obere Teil der vertikalen elektrischen Verbindung (127a) aufweist.

8. Bauteilträger (100) nach Anspruch 7,
wobei der obere Teil der vertikalen elektrischen Verbindung (127a) auf der gleichen vertikalen Höhe (z) wie die Basisstruktur (121) angeordnet ist.

9. Bauteilträger (100) nach einem der vorhergehenden Ansprüche, ferner umfassend:
eine Klebstoffschicht (122), die in den Stapel (101) eingebettet und unter der thermischen Struktur (120) angeordnet ist.

10. Anordnung (200), insbesondere System-in-Package, umfassend:
einen Bauteilträger (100) nach einem der vorhergehenden Ansprüche; und
einen weiteren, auf der Hauptfläche (105) des Bauteilträgers (100) gestapelten Bauteilträger (201), insbesondere wobei der weitere Bauteilträger (201) mindestens ein weiteres elektronisches Bauteil (210) umfasst.

11. Verfahren zur Herstellung eines Bauteilträgers (100), das Verfahren umfassend:
Bilden eines Stapels (101), umfassend mindestens eine elektrisch leitfähige Schichtstruktur (104) und/oder mindestens eine elektrisch isolierende Schichtstruktur (102);
Einbetten eines elektronischen Bauteils (110) in den Stapel (101); und
Bilden einer thermischen Struktur (120), sodass die thermische Struktur (120) thermische Energie, die von dem elektronischen Bauteil (110) erzeugt wird, zu einer Hauptfläche (105) des Stapels (101) abführt;
Bilden einer vertikalen elektrischen Verbindung (127), die in den Stapel (101) eingebettet ist;
Bilden einer Metallstruktur (128, 129), die neben der thermischen Struktur (120) angeordnet ist, wobei sich die Metallstruktur (128, 129) zumindest teilweise über die Hauptfläche (105) hinaus erstreckt;
wobei die thermische Struktur (120) eine Basisstruktur (121) umfasst, die zumindest teilweise in den Stapel (101) eingebettet ist, wobei die Basisstruktur (121) die äußerste Schicht des Stapels (101) ist, insbesondere bündig mit einer der Schichtstrukturen (102, 104) des Stapels (101), und eine Vielzahl von Vorsprüngen (125), die von der Basisstruktur (121) vorstehen und sich über die Hauptfläche (105) des Stapels (101) hinaus erstrecken; und
wobei die Metallstruktur (128, 129) die gleiche Höhe wie die Vielzahl von Vorsprüngen (125) aufweist.

12. Verfahren nach Anspruch 11, ferner umfassend:
Bilden der thermischen Struktur (120) auf einem temporären Träger (140), insbesondere einem gewebebasierten temporären Träger (140), insbesondere einem temporären DCF-Träger (140).

13. Verfahren nach Anspruch 11 oder 12, ferner umfassend:
Bereitstellen einer hochtemperaturbeständigen dielektrischen Schicht (160), insbesondere eines Photo-Resists, insbesondere eines Trockenfilm-Resists;
Strukturieren der hochtemperaturbeständigen Schicht (160), um eine strukturierte Schicht mit Vertiefungen zu erhalten; und
Bilden der Vielzahl von Vorsprüngen (125) in den Vertiefungen der strukturierten Schicht, insbesondere durch Plattieren.

14. Verfahren nach Anspruch 13, ferner umfassend:
Bilden einer photoabbildbaren dielektrischen PID-Schichtstruktur (150) auf der hochtemperaturbeständigen Schicht (160), insbesondere auf der strukturierten Schicht mit der Vielzahl von Vorsprüngen (125);
Entfernen eines Teils der PID-Struktur (150), wodurch ein Basisstrukturhohlraum gebildet wird; und
Bilden der Basisstruktur (121) in dem Basisstrukturhohlraum, insbesondere durch Plattieren.

15. Verfahren nach einem der Ansprüche 11 bis 14, ferner umfassend:
Bilden der Basisstruktur (121) nach dem Bilden der Vielzahl von Vorsprüngen (125) auf der Vielzahl von Vorsprüngen (125), insbesondere durch Plattieren.

## Revendications

1. Support de composants (100), dans lequel le support de composants (100) comprend :
un empilement (101) comprenant au moins une structure de couche électroconductrice (104) et/ou au moins une structure de couche électro-isolante (102), un composant électronique (110) intégré dans l'empilement (101) ; et une structure thermique (120), configurée pour dissiper l'énergie thermique produite par le composant électronique (110) vers et au-delà d'une surface principale (105) de l'empilement (101) ;
une connexion électrique verticale (127) intégrée dans l'empilement (101) ;
une structure métallique (128, 129) agencée à côté de la structure thermique (120), dans lequel la structure métallique (128, 129) s'étend au moins partiellement au-delà de la surface principale (105) ;
dans lequel la structure thermique (120) comprend :
une structure de base (121) au moins partiellement intégrée dans l'empilement (101), ladite structure de base (121) étant la couche la plus extérieure de l'empilement (101), en particulier à niveau avec l'une des structures de couche (102, 104) de l'empilement (101), et
une pluralité de saillies (125), faisant saillie à partir de la structure de base (121), et s'étendant au-delà de la surface principale (105) de l'empilement (101) ; et dans lequel la structure métallique (128, 129) comprend la même hauteur que la pluralité de saillies (125).

2. Support de composants (100) selon la revendication 1, comprenant en outre :
une structure de couche de redistribution (130), au moins partiellement intégrée dans l'empilement (101) et configurée pour connecter électriquement le composant électronique intégré (110) à une autre surface principale (106) de l'empilement (101), en particulier dans lequel l'autre surface principale (106) est opposée à la surface principale (105).

3. Support de composants (100) selon la revendication 1 ou 2,
dans lequel le support de composants (100) est configuré comme un support de composants sans noyau ; ou
dans lequel le support de composants (100) est configuré comme un boîtier au niveau plaquette de type fan-out ou un boîtier au niveau panneau de type fan-out ; ou
dans lequel le support de composants (100) est configuré sous la forme d'un boîtier haute densité pour la production de chaleur ; ou
dans lequel la structure thermique (120) est configurée comme une partie intégrante de l'empilement (101).

4. Support de composants (100) selon l'une quelconque des revendications précédentes, dans lequel la structure thermique (120) comprend en outre :
une couche de revêtement (126), en particulier un fini de surface, qui recouvre la pluralité de saillies (125).

5. Support de composants (100) selon l'une quelconque des revendications précédentes, dans lequel la pluralité de saillies (125) comprend une hauteur dans la plage de 100 µm à 200 µm ; ou
dans lequel la pluralité de saillies (125) comprend des parois latérales essentiellement verticales, en particulier reflétant ainsi une étape de fabrication de photolithographie ; ou
dans lequel les saillies de la pluralité de saillies (125) comprennent la même forme ; ou
dans lequel la structure de base (121) comprend une largeur plus grande que le composant électronique (110) ; ou
dans lequel le composant électronique (110) est intégré dans une cavité, en particulier encapsulé (103) dans la cavité, et dans lequel la structure de base (121) comprend une largeur plus grande que la cavité ; ou
dans lequel un chemin thermique (T) est établi directement depuis le composant électronique (110) jusqu'à la structure thermique (120) sans un matériau électro-isolant entre les deux.

6. Support de composants (100) selon l'une quelconque des revendications précédentes, dans lequel la connexion électrique verticale (127) s'étend à travers l'empilement (101), dans lequel une partie supérieure de la connexion électrique verticale (127a) peut être connectée électriquement au niveau de la surface principale (105) de l'empilement (101).

7. Support de composants (100) selon l'une quelconque des revendications précédentes, dans lequel la structure métallique (128, 129) forme la portion la plus extérieure de la connexion électrique verticale (127), en particulier dans lequel la structure métallique (128, 129) comprend une largeur plus grande que la partie supérieure de la connexion électrique verticale (127a).

8. Support de composants (100) selon la revendication 7,
dans lequel la partie supérieure de la connexion électrique verticale (127a) est agencée à la même hauteur verticale (z) que la structure de base (121).

9. Support de composants (100) selon l'une quelconque des revendications précédentes, comprenant en outre :
une couche adhésive (122), intégrée dans l'empilement (101) et agencée sous la structure thermique (120).

10. Agencement (200), en particulier un boîtier-système, comprenant :
un support de composants (100) selon l'une quelconque des revendications précédentes ; et
un autre support de composants (201), empilé sur la surface principale (105) du support de composants (100), en particulier dans lequel l'autre support de composants (201) comprend au moins un autre composant électronique (210).

11. Procédé de fabrication d'un support de composants (100), le procédé comprenant :
la formation d'un empilement (101) comprenant au moins une structure de couche électroconductrice (104) et/ou au moins une structure de couche électro-isolante (102) ;
l'intégration d'un composant électronique (110) dans l'empilement (101) ; et
la formation d'une structure thermique (120), de sorte que la structure thermique (120) dissipe l'énergie thermique produite par le composant électronique (110) vers une surface principale (105) de l'empilement (101) ;
la formation d'une connexion électrique verticale (127) intégrée dans l'empilement (101) ;
la formation d'une structure métallique (128, 129) agencée à côté de la structure thermique (120), dans lequel la structure métallique (128, 129) s'étend au moins partiellement au-delà de la surface principale (105) ;
dans lequel la structure thermique (120) comprend une structure de base (121) au moins partiellement intégrée dans l'empilement (101), ladite structure de base (121) étant la couche la plus extérieure de l'empilement (101), en particulier affleurant l'une des structures de couche (102, 104) de l'empilement (101), et une pluralité de saillies (125), faisant saillie depuis la structure de base (121), et s'étendant au-delà de la surface principale (105) de l'empilement (101) ; et
dans lequel la structure métallique (128, 129) comprend la même hauteur que la pluralité de saillies (125).

12. Procédé selon la revendication 11, comprenant en outre :
la formation de la structure thermique (120) sur un support temporaire (140), en particulier un support temporaire à base de tissu (140), plus particulièrement un support temporaire DCF (140).

13. Procédé selon la revendication 11 ou 12, comprenant en outre :
la fourniture d'une couche diélectrique résistante aux hautes températures (160), en particulier une photorésine, plus particulièrement une résine solide photosensible ;
la structuration de la couche résistante aux hautes températures (160) pour obtenir une couche structurée avec des évidements ; et
la formation de la pluralité de saillies (125) dans les évidements de la couche structurée, en particulier par placage.

14. Procédé selon la revendication 13, comprenant en outre :
la formation d'une structure de couche de diélectrique photosensible, PID, (150) sur la couche résistante aux hautes températures (160), en particulier sur la couche structurée avec la pluralité de saillies (125) ;
le retrait d'une partie de la structure PID (150), formant ainsi une cavité de structure de base ; et
la formation de la structure de base (121) dans la cavité de structure de base, en particulier par placage.

15. Procédé selon l'une quelconque des revendications 11 à 14, comprenant en outre :
la formation de la structure de base (121) ultérieurement à la formation de la pluralité de saillies (125) sur le dessus de la pluralité de saillies (125), en particulier par placage.
